(19) Europäisches Patentamt
European Patent Office
Office européen des brevets

(11) **EP 4 293 422 A1**

(12) **EUROPEAN PATENT APPLICATION**
published in accordance with Art. 153(4) EPC

(43) Date of publication:
**20.12.2023 Bulletin 2023/51**

(21) Application number: **22752739.7**

(22) Date of filing: **08.02.2022**

(51) International Patent Classification (IPC):
**G03F 1/24** *(2012.01)*      **G03F 1/54** *(2012.01)*

(52) Cooperative Patent Classification (CPC):
**G03F 1/24; G03F 1/54**

(86) International application number:
**PCT/JP2022/004919**

(87) International publication number:
**WO 2022/172916 (18.08.2022 Gazette 2022/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.02.2021 JP 2021022055**

(71) Applicant: **Toppan Photomask Co., Ltd.
Tokyo 108-0023 (JP)**

(72) Inventors:
• **GODA, Ayumi**
  **Tokyo 110-0016 (JP)**
• **NAKANO, Hideaki**
  **Tokyo 110-0016 (JP)**
• **ICHIKAWA, Kenjiro**
  **Tokyo 110-0016 (JP)**
• **YAMAGATA, Yuto**
  **Tokyo 110-0016 (JP)**

(74) Representative: **Hoffmann Eitle
Patent- und Rechtsanwälte PartmbB
Arabellastraße 30
81925 München (DE)**

(54) **REFLECTIVE PHOTOMASK BLANK AND REFLECTIVE PHOTOMASK**

(57)    There are provided a reflective photomask and a reflective photomask blank having a high contrast of a minute pattern to an inspection light and capable of minimizing the shadowing effect in EUV exposure. A reflective photomask blank (100) of this embodiment includes: a substrate (11); a reflective part (17); and a low reflective part (18), in which the low reflective part (18) is a multi-layer structural body having at least two or more layers including an absorption layer (14) and an outermost layer (15), an extinction coefficient k to a wavelength of 13.5 nm of the absorption layer (14) is k > 0.041, and the film thickness of the low reflective part (18) is a film thickness satisfying $0.5 \times da + dc \leq 21.5$ nm or a film thickness satisfying $0.5 \times da + dc \geq 27.5$ nm, wherein the film thickness of the absorption layer (14) is da and the film thickness of the outermost layer (15) is dc.

FIG. 1

EP 4 293 422 A1

**Description**

Technical Field

The present disclosure relates to a reflective photomask blank and a reflective photomask.

Background Art

In a manufacturing process of semiconductor devices, a demand for miniaturization by a photolithography technology has increased with the miniaturization of the semiconductor devices. The minimum development dimension of a transfer pattern in the photolithography largely depends on the wavelength of an exposure light source, and the minimum resolution dimension can be made smaller as the wavelength is shorter. Therefore, as the exposure light source in a manufacturing process of advanced semiconductor devices, an EUV (Extreme Ultraviolet) having a wavelength of 13.5 nm has been introduced in place of a conventional ArF excimer laser light having a wavelength of 193 nm.

Most materials have high light absorptivity to the EUV, and therefore a conventional dioptric system utilizing light transmission cannot be used. Thus, an optical member of an exposure machine is not a lens but a mirror. A photomask is also a reflective EUV photomask in place of a conventional transmission-type photomask. An incident light and a reflected light on the EUV photomask cannot be coaxially designed. Thus, in the EUV lithography, a technique is commonly employed which includes making the EUV light incident by tilting the optical axis by 6° from the vertical direction of the EUV photomask and guiding a reflected light reflected at an angle of -6° to a semiconductor substrate. As described above, the optical axis is tilted, causing a problem referred to as a shadowing effect in which the EUV light incident on the EUV photomask creates a shadow of a mask pattern (absorption layer pattern) on the EUV photomask, deteriorating the transfer performance. Thus, it is a problem to be solved to reduce the shadowing effect and enhance the transfer performance.

To solve the problem, a reflective photomask has been proposed which reduces the shadowing effect by using a material having a high extinction coefficient k for an absorption layer to suppress the EUV reflectance, enabling the formation of the absorption layer pattern having a smaller film thickness than before (see, PTL 1, for example).

In recent years, with the miniaturization of a mask pattern, a minute pattern dimensional error or positional error or the like, which has not previously posed a problem, is regarded as a defect after transfer, causing a reduction in yield. Therefore, more highly accurate inspection is becoming necessary. A light source having a wavelength of 250 to 270 nm has been generally used in the inspection of an advanced mask. However, a higher resolution is required, and therefore the application of a light source having a wavelength of 190 to 200 nm has been studied. A higher contrast between the absorption layer pattern and a reflective layer is generally advantageous for the detection of microdefects. Thus, a photomask having a high contrast to the wavelengths of 190 to 200 nm has been expected. Further, when a Ru protective layer is formed between the reflective layer and the absorption layer, the deep ultraviolet (DUV) reflectance from the protective layer is lower than that in a case where the protective layer is not provided, which has posed a problem of causing a reduction in contrast. Therefore, it is a problem to be solved object to improve an absorption film and a multi-layer film containing an absorption film to enhance the contrast and improve the inspection property.

To solve the problem, PTL 2 discloses a method for enhancing both the EUV contrast and the contrast of an inspection light having a wavelength of 200 nm or less by forming a mixed film of Si and a transition metal with adjusted nitrogen and oxygen contents for enhancing the inspection light contrast on an absorption layer containing Ta or Cr as a main material.

However, in the method in PTL 2, a method for forming a low reflective part to the DUV light on the absorption layer is described, but PTL 2 does not mention that the formation of the low reflective part increases the total film thickness of an absorbption layer and the low reflective part, resulting in an increase in the shadowing effect, and thus it is not revealed that an EUV photomask has high transferability. Further, in the method in PTL 2, the contrast is defined only by comparing the absorption layer and the reflective layer in a solid part without a pattern, and therefore it is not revealed that a minute pattern of the structure can be distinct and clear.

Citation List

Patent Literatures

PTL 1: JP 6408790 B
PTL 2: JP 2015-84447 A

Summary of Invention

Technical Problem

It is an object of the present disclosure to provide a reflective photomask and a reflective photomask blank having a high contrast of a minute pattern to an inspection light and capable of minimizing the shadowing effect in EUV exposure.

Solution to Problem

To achieve the above-described object, a reflective photomask blank according to one aspect of the present disclosure includes: a substrate; a reflective part formed on the substrate and configured to reflect an incident light; and a low reflective part formed on the reflective part and configured to absorb an incident light, in which the low reflective part is a multi-layer structural body having at least two or more layers including an absorption layer and an outermost layer, the extinction coefficient k to a wavelength of 13.5 nm of the absorption layer is k > 0.041, and the film thickness of the low reflective part is a film thickness satisfying $0.5 \times da + dc \leq 21.5$ nm or a film thickness satisfying $0.5 \times da + dc \geq 27.5$ nm, wherein the film thickness of the absorption layer is da and the film thickness of the outermost layer is dc.

A reflective photomask according to one aspect of the present disclosure includes: a substrate; a reflective part formed on the substrate and configured to reflect an incident light; and a low reflective part formed on the reflective part and configured to absorb an incident light, in which the low reflective part is a multi-layer structural body having at least two or more layers including an absorption layer and an outermost layer, the extinction coefficient k to a wavelength of 13.5 nm of the absorption layer is k > 0.041, and the film thickness of the low reflective part is a film thickness satisfying $0.5 \times dc + dc \leq 21.5$ nm or a film thickness satisfying $0.5 \times da + dc \geq 27.5$ nm, wherein the film thickness of the absorption layer is da and the film thickness of the outermost layer is dc.

Preferably, the extinction coefficient k to the wavelength of 13.5 nm of the absorption layer is k > 0.041, and the refractive index n of the absorption layer is n ≤ 0.98.

Preferably, at least one layer of the absorption layer of the low reflective part contains a total of 50 at% or more of one or more kinds from among a first material group, and the first material group contains tellurium (Te), cobalt (Co), nickel (Ni), tin (Sn), platinum (Pt), indium (In), silver (Ag), copper (Cu), zinc (Zn), and bismuth (Bi), and oxides, nitrides, and oxynitrides thereof.

Preferably, the absorption layer of the low reflective part contains a total of 50 at% or more of one or more kinds from among tin (Sn) and indium (In), and oxides, nitrides, and oxynitrides thereof, the outermost layer of the low reflective part contains a total of 50 at% or more of one or more kinds from among a second material group, and the second material group contains a total of 50 at% or more of one or more kinds of silicon (Si), titanium (Ti), tantalum (Ta), Chromium(Cr), molybdenum (Mo), and ruthenium (Ru), and oxides, nitrides, and oxynitrides thereof.

Preferably, the low reflective part is a thin film containing a mixed material in which the mixing ratio of a mixture of a material selected from the first material group and other materials is determined and which has a total film thickness of 17 nm or more and 45 nm or less, even when the low reflective part is divided into a plurality of layers, and has an OD value (Optical Density) of 1.0 or more.

Advantageous Effects of Invention

The reflective photomask and the reflective photomask blank for producing the same according to one aspect of the present disclosure makes it possible to provide a reflective photomask and a reflective photomask blank having a high contrast of a minute pattern to an inspection light, capable of minimizing the shadowing effect in EUV exposure, and being advantageous for defect guarantee and having good transferability.

Brief Description of Drawings

FIG. 1 is a cross-sectional view schematically illustrating one configuration example of a reflective photomask blank according to this embodiment;
FIG. 2 is a cross-sectional view schematically illustrating one configuration example of a reflective photomask according to this embodiment;
FIG. 3 is a graph showing the optical constant of each metal at the wavelength of an EUV light;
FIG. 4 is a schematic cross-sectional view illustrating a manufacturing process of the reflective photomask according to this embodiment;

FIG. 5 is a schematic cross-sectional view illustrating a manufacturing process of the reflective photomask according to this embodiment;

FIG. 6 is a schematic cross-sectional view illustrating a manufacturing process of the reflective photomask according to this embodiment;

FIG. 7 is a schematic cross-sectional view illustrating a manufacturing process of the reflective photomask according to this embodiment;

FIG. 8 is a schematic cross-sectional view illustrating a manufacturing process of the reflective photomask according to this embodiment; and

FIG. 9 is a schematic plan view illustrating a design pattern of a reflective photomask according to Examples of the present invention.

Description of Embodiments

One embodiment of the present disclosure will now be described with reference to the drawings.

Herein, the configurations illustrated in the drawings are schematic, and the relationship between the thickness and the plane dimension, the thickness ratio of each layer, and the like are different from the actual relationship, ratio, and the like. The embodiment described below exemplifies configurations for embodying the technical idea of the present disclosure. In the technical idea of the present disclosure, materials, shapes, structures, and the like of constituent components are not limited to the materials, shapes, structures, and the like described below. The technical idea of the present disclosure can be variously altered within the technical range defined by Claims.

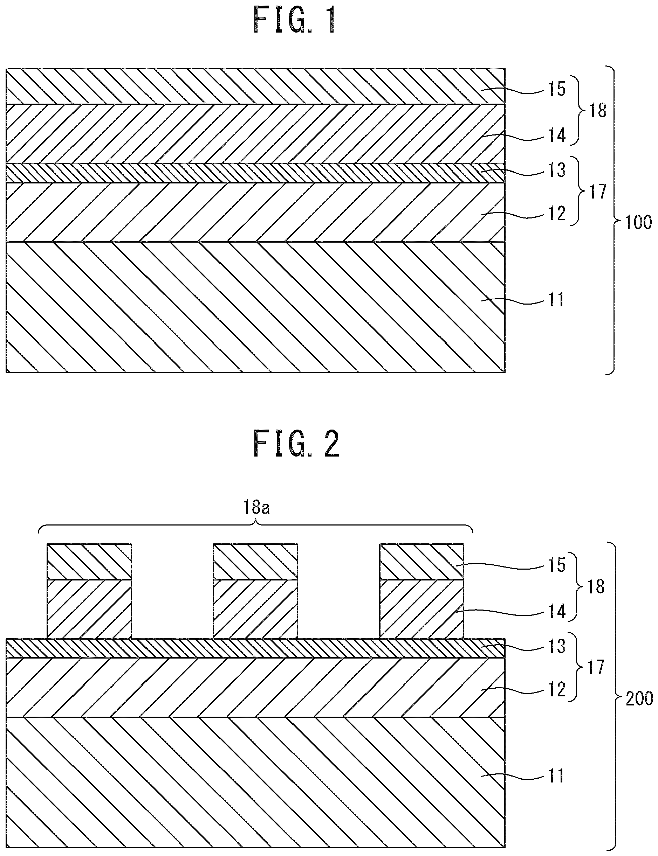

FIG. 1 is a schematic cross-sectional view illustrating a reflective photomask blank 100 according to an embodiment of the present invention. FIG. 2 is a schematic cross-sectional view illustrating a reflective photomask 200 according to an embodiment of the present invention. The reflective photomask 200 according to the embodiment of the present invention illustrated in FIG. 2 is formed by patterning a low reflective part 18 of the reflective photomask blank 100 according to the embodiment of the present invention illustrated in FIG. 1.

(Configuration of reflective photomask blank)

The basic configuration of the reflective photomask blank according to the embodiment of the present disclosure is described using FIG. 1.

As illustrated in FIG. 1, the reflective photomask blank 100 according to one embodiment of the present disclosure includes a substrate 11, a reflective part 17 formed on the substrate 11, and the low reflective part 18 formed on the reflective part 17. The reflective photomask blank 100 further includes a multi-layer reflective film 12 and a capping layer 13 in the reflective part 17 and includes an absorption layer 14 and an outermost layer 15 in the low reflective part 18. More specifically, the reflective photomask 200 has the multi-layer reflective film 12, the capping layer 13, the absorption layer 14, and the outermost layer 15 deposited in this order on one surface side of the substrate 11. Hereinafter, each layer is described in detail.

(Substrate)

The substrate 11 is a layer serving as a base of the reflective photomask blank 100. For the substrate 11 according to the embodiment of the present invention, a flat Si substrate, synthetic quartz substrate, or the like is usable. Further, a low thermal expansion glass to which titanium is added is usable for the substrate 11. However, the present invention is not limited to the above, and any material having a small thermal expansion coefficient may be acceptable.

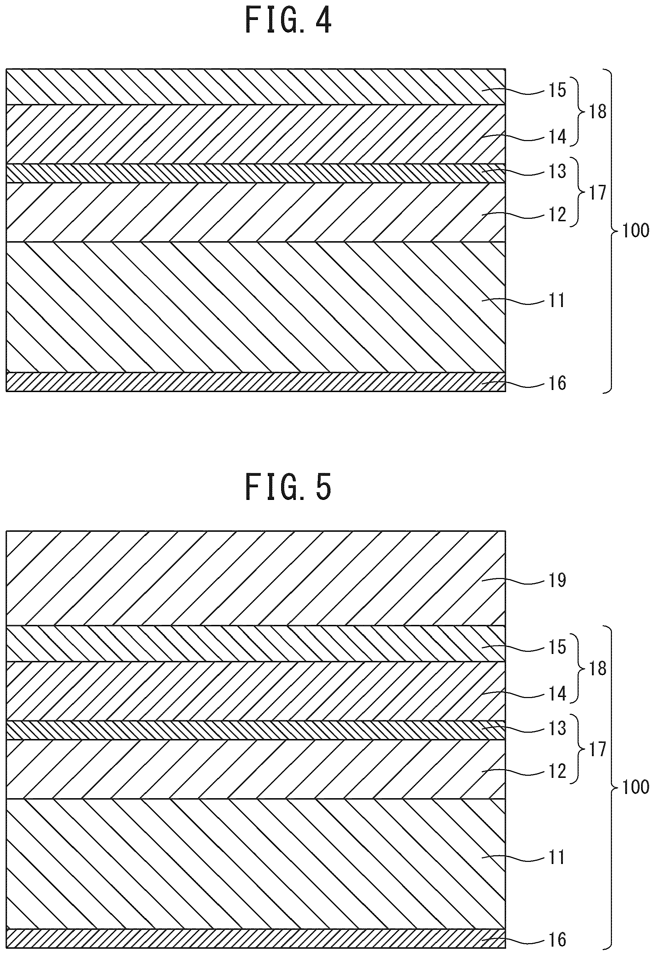

As illustrated in FIG. 4, a back surface conductive film 16 can be formed on the surface on which the multi-layer reflective film 12 is not formed of the substrate 11. The back surface conductive film 16 is a film for fixing the reflective photomask blank 100 utilizing the principle of an electrostatic chuck when the reflective photomask blank 100 is installed in an exposure machine.

(Reflective part)

The reflective part 17 is formed on the substrate 11 and is provided to reflect a light incident on the reflective photomask blank 100. The reflective part 17 includes the multi-layer reflective film 12 and the capping layer 13.

(Multi-layer reflective film)

The multi-layer reflective film 12 is a layer formed on the substrate 11 and is a layer provided to reflect an EUV light (extreme ultraviolet light) which is an exposure light in the reflective photomask blank 100.

The multi-layer reflective film 12 contains a plurality of reflective films containing a combination of materials having greatly different refractive indices to the EUV light. For example, the multi-layer reflective film 12 can be formed by repeatedly depositing a layer containing a combination of Mo (molybdenum) and Si (silicon) or Mo (molybdenum) and Be (beryllium) by about 40 cycles.

(Capping layer)

The capping layer 13 is a layer formed on the multi-layer reflective film 12 and is a layer functioning as an etching stopper to prevent damage to the multi-layer reflective film 12 when an absorption layer pattern is etched. The capping layer 13 according to the embodiment of the present invention is formed of a material resistant to dry etching performed in pattern formation of the absorption layer 14. For example, ruthenium (Ru) is generally applied to the capping layer 13. The capping layer 13 may not be provided depending on materials of the multi-layer reflective film 12 and etching conditions.

(Low reflective part)

The low reflective part 18 is a layer formed on the reflective part 17 and provided to absorb an EUV light, which is an exposure light, in the reflective photomask blank 100. The low reflective part 18 includes the absorption layer 14 and the outermost layer 15. The low reflective part 18 contains at least two or more layers, one of which is the absorption layer 14, and the outermost layer 15 is provided on the absorption layer 14.

(Absorption layer)

The absorption layer 14 is a layer formed on the capping layer 13 and is a layer containing at least one or more layers. The absorption layer 14 is a layer forming the absorption layer pattern (transfer pattern) which is a fine pattern for transfer.

As illustrated in FIG. 2, an absorption pattern (absorption layer pattern) of the reflective photomask 200 is formed by removing a part of the absorption layer 14 of the reflective photomask blank, i.e., patterning the absorption layer 14. In the EUV lithography, the EUV light is obliquely incident and reflected on the reflective part 17, but the transfer performance onto a wafer (semiconductor substrate) sometimes deteriorates due to a shadowing effect in which a low reflective part pattern 18a interferes with an optical path. This deterioration of the transfer performance is reduced by reducing the thickness of the low reflective part 18 absorbing the EUV light.

To reduce the thickness of the low reflective part 18, a material having higher absorptivity to the EUV light than that of a conventional material, i.e., a material having a high extinction coefficient k to a wavelength of 13.5 nm, is preferably applied to the low reflective part 18.

The extinction coefficient k of tantalum (Ta), which is a main material of the conventional absorption layer 14, is 0.041. When the main material of the absorption layer 14 is a compound material having the extinction coefficient k larger than that of tantalum (Ta), the thickness of the absorption layer 14 can be further reduced as compared with conventional compound materials, and the shadowing effect can be reduced.

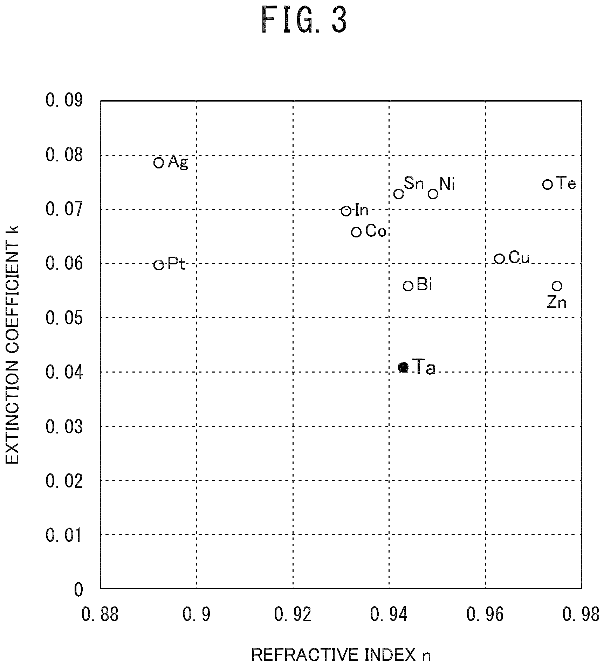

FIG. 3 is a graph showing the optical constants of tantalum (Ta), which is the conventional material, and a first material group. The first material group contains tellurium (Te), cobalt (Co), nickel (Ni), tin (Sn), platinum (Pt), indium (In), silver (Ag), copper (Cu), zinc (Zn), and bismuth (Bi), and oxides, nitrides, and oxynitrides thereof. The horizontal axis of FIG. 3 represents the refractive index n and the vertical axis represents the extinction coefficient k. FIG. 3 shows that the shadowing effect can be reduced by using the first material group because the materials in the first material group each have the extinction coefficient k larger than that of the conventional material.

The first material group has the refractive index n to the wavelength of 13.5 nm of $n \leq 0.98$. More specifically, the enhancement of the phase shift effect can be expected by using the refractive index of $n \leq 0.98$ of the first material group.

The contrast of a minute pattern to an inspection light is calculated using the reflectance of the reflective layer (reflective part) and the reflectance of the low reflective part. Specifically, the contrast is calculated according to Equation (1) below, wherein the reflectance of the reflective layer is Rm and the reflectance of the low reflective part is Ra.

$$(Rm - Ra)/(Rm + Ra) \times 100 \cdots \text{Equation (1)}$$

The light source in the optical inspection has a wavelength of about 190 to 270 nm. When the light source has a wavelength of about 190 to 270 nm, higher resolution can be obtained.

In the case of a reflectance distribution of a minute pattern, Rm > Ra is not always established and an inverted pattern, Rm < Ra, is sometimes established. In such a case, an image is clearer when the contrast is negatively large. Therefore, the range of the contrast in which the pattern can be distinct in Equation (1) is smaller than -0.1 and larger than 0.1.

The contrast depends on the pattern dimension or the photomask structure to be inspected. When a minute pattern of 100 nm or less is inspected, the film thickness of the low reflective part 18 desirably satisfies $0.5 \times da + dc \leq 21.5$ (nm) or satisfies $0.5 \times da + dc \geq 27.5$ (nm) in the relationship between the film thickness da (nm) of the absorption layer and the film thickness dc (nm) of the outermost layer. When the film thickness of the low reflective part 18 satisfies $0.5 \times da + dc \leq 21.5$ (nm), the low reflective part 18 is a thin film, and therefore the contrast increases due to the phase shift effect. When the film thickness of the low reflective part 18 satisfies $0.5 \times da + dc \geq 27.5$ (nm), a positively large and sufficient contrast is obtained in a relatively large dimension, and, invertedly, a negatively large contrast is obtained in a minute pattern.

An optical density (OD) value is an index showing the light intensity contrast between the reflective part 17 and the low reflective part 18 and is defined by Equation (2) below.

$$OD = -\log (Ra/Rm) \cdots \text{Equation (2)}$$

Compound materials containing tantalum (Ta) as a main ingredient have been applied to the absorption layer in a conventional EUV reflective mask as described above. When the main ingredient of the absorption layer is tantalum (Ta), the film thickness needed to be 40 nm or more to have the optical density OD value to the EUV light of 1 or more. To have the OD value of 2 or more, the film thickness needed to be 70 nm or more.

In this embodiment, with respect to the film thickness of the low reflective part 18, the total film thickness of the low reflective part 18 is desirably within the range of 17 nm or more and 45 nm or less even when the absorption layer is divided into a plurality of layers. Due to that the film thickness of the absorption layer 14 is within the range above, the contrast required in an inspection can be sufficiently obtained.

The larger the OD value is, the better the contrast is, and the higher transferability is obtained. For the pattern transfer, the OD value needs to be larger than 1. In this embodiment, the OD value of 1.5 or more is more preferable by comparison with the conventional case above.

The first material group has the extinction coefficient k to the EUV light higher than that of the conventional material tantalum (Ta) and can be applied to the absorption layer 14 of the low reflective part 18. The application of the first material group to the absorption layer 14 can reduce the thickness of the low reflective part 18 and reduce the shadowing effect, and thus the enhancement of the transferability can be expected. To further reduce the shadowing effect as compared with a conventional film, the absorption layer 14 desirably contains at least 50 at% or more of the first material group.

When the absorption layer 14 is a material that can be etched using a fluorine-based gas or a chlorine-based gas, a fine pattern can be formed without significant changes from a conventional manufacturing process. Tin (Sn) and indium (In) can be etched using a chlorine-based gas. Oxides, oxynitrides of tin and oxides, nitrides, oxynitrides of indium have high melting points and high resistance to heat, making them suitable for use in an environment where the temperature increases due to the absorption of the EUV light. For chemical stability, it is desirable that the atomic number ratio of oxygen to tin is 1.5 or more, the atomic number ratio of oxygen and indium is 1.0 or more, and the atomic number ratio of nitrogen and indium is 0.5 or more.

The compound materials of the absorption layer 14 may be mixed with other materials, in addition to the first material group, for amorphous properties, cleaning resistance, mixing prevention, phase shift, and the like.

(Outermost layer)

For the materials of the outermost layer 15, at least one or more materials can be selected from a second material group that can be etched using a fluorine-based gas or a chlorine-based gas. The second material group contains silicon (Si), titanium (Ti), tantalum (Ta), chromium (Cr), ruthenium (Ru), and molybdenum (Mo), and oxides, nitrides, and oxynitrides thereof. Not to reduce the etching rate, the outermost layer 15 desirably contains a material containing at least 50% or more of the materials of the second material group.

When the absorption layer 14 contains tin or indium that can be etched using a chlorine gas, tantalum nitride or molybdenum that can be etched similarly using a chlorine-based gas can be suitably selected also in the outermost layer 15. In this case, the low reflective part can be etched in a single process, and therefore the simplification of the process or a reduction in contamination can be expected.

For the outermost layer 15, tantalum oxide or oxides, nitrides, and oxynitrides of silicon that can be etched using a fluorine-based gas can also be suitably selected. In this case, the outermost layer 15 is also usable as an etching mask, and therefore can be expected to enhance the rectangularity of a pattern and reduce a dimensional variation due to a loading effect.

The boundary between the outermost layer 15 and the absorption layer 14 is not necessarily required to be clear, and a single layer may be acceptable in which the composition ratio continuously changes.

A mixed material of the outermost layer 15 may be mixed with other materials, in addition to the second material group, for amorphous properties, cleaning resistance, mixing prevention, phase shift, and the like.

(Method for manufacturing reflective photomask)

Next, a method for manufacturing a reflective photomask is described using FIGS. 4 to 8.

As illustrated in FIG. 4, a positive chemically amplified resist (SEBP9012: manufactured by Shin-Etsu Chemical Co., Ltd.) was formed by spin coating to have a film thickness of 120 nm on the low reflective part 18 provided in the reflective photomask blank 100. Thereafter, the resist was baked at 110°C for 10 min to form a resist film 19 as illustrated in FIG. 5.

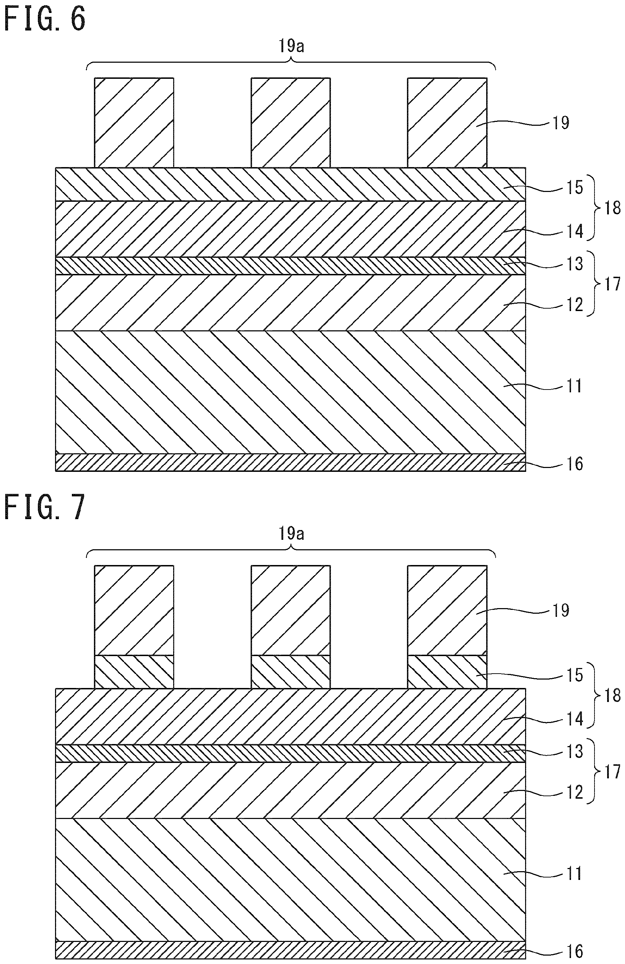

Next, a predetermined pattern was drawn on the resist film 19 formed of the positive chemically amplified resist by an electron beam lithography machine (JBX3030: manufactured by JEOL). Thereafter, baking treatment was performed at 110°C for 10 minutes, followed by spray development (SFG3000: manufactured by Sigma Meltec). Thus, a resist pattern 19a was formed as illustrated in FIG. 6.

Next, the outermost layer 15 was patterned by dry etching mainly using a fluorine-based gas with the resist pattern 19a as an etching mask to form an outermost layer pattern as illustrated in FIG. 7.

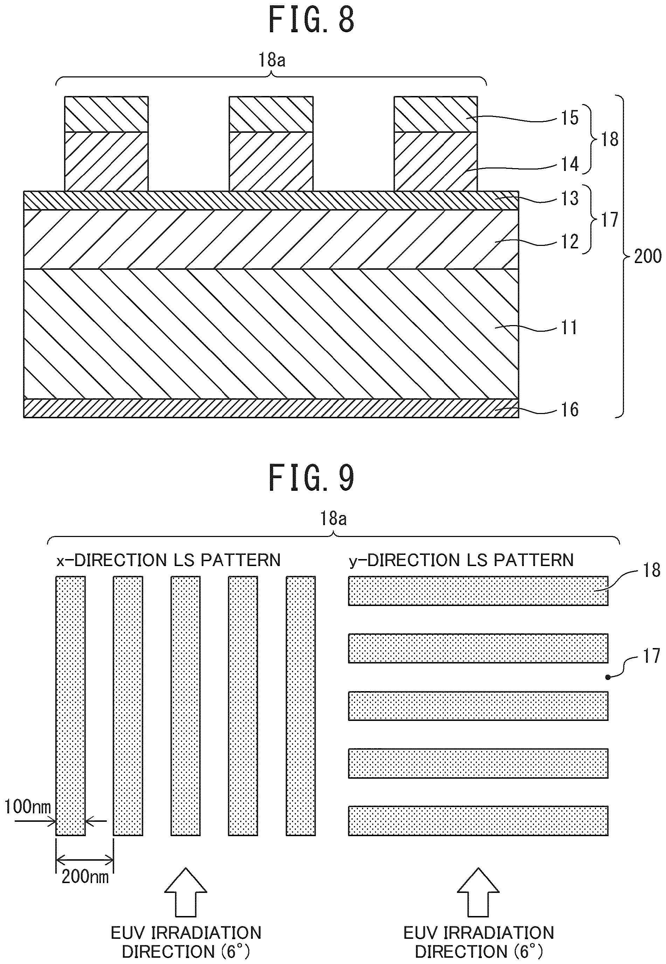

Next, the absorption layer 14 was patterned by dry etching mainly using a chlorine-based gas with the resist pattern 19a as an etching mask to form an absorption layer pattern as illustrated in FIG. 8. Thus, the low reflective part pattern 18a including the outermost layer pattern and the absorption layer pattern was formed.

Next, the remaining resist pattern 19a was washed away, thereby exposing the low reflective part pattern 18a. Thus, the reflective photomask 200 according to this embodiment was manufactured. The low reflective part pattern 18a formed in the low reflective part 18 contains an LS (line and space) pattern with a line width of 100 nm, an LS pattern with a line width of 200 nm for film thickness measurement of the absorption layer using AFM, and a 4 mm square low reflective part removed part for EUV reflectance measurement on the reflective photomask 200 for transfer evaluation. The LS pattern with a line width of 100 nm was designed in each of the x-direction and the y-direction as illustrated in FIG. 9 such that the influence of the shadowing effect by EUV oblique irradiation was able to be easily viewed.

<Effects of this embodiment>

The reflective photomask blank 100 and the reflective photomask 200 according to this embodiment have the following effects.

(1) In the reflective photomask blank 100 of this embodiment, the extinction coefficient k to the wavelength of 13.5 nm in the absorption layer 14 is k > 0.041.

According to this configuration, the low reflective part 18 can be reduced in thickness and the shadowing effect can be reduced by using the material having higher absorptivity to the EUV light than that of conventional materials.

(2) In the reflective photomask blank 100 of this embodiment, the film thickness of the low reflective part is a film thickness satisfying $0.5 \times da + dc \le 21.5$ nm or a film thickness satisfying $0.5 \times da + dc \ge 27.5$ nm, wherein the film thickness of the absorption layer is da and the film thickness of the outermost layer is dc.

According to this configuration, sufficient contrast can be obtained and the transferability increases.

(3) In the reflective photomask blank 100 of this embodiment, the absorption layer 14 contains a total of 50 at% or more of one or more elements selected from the first material group. The first material group contains tellurium (Te), cobalt (Co), nickel (Ni), tin (Sn), platinum (Pt), indium (In), silver (Ag), copper (Cu), zinc (Zn), and bismuth (Bi), and oxides, nitrides, and oxynitrides.

According to this configuration, the low reflective part 18 can be reduced in thickness and the shadowing effect can be reduced.

EXAMPLES

Hereinafter, the present disclosure is described in more detail with respect to Examples but the present disclosure is not limited by Examples at all.

<Example 1>

A synthetic quartz substrate having low thermal expansion properties was used as a substrate. On the substrate, a multi-layer reflective film was formed by depositing 40 multi-layer films each containing a pair of silicon (Si) and molybdenum (Mo). The film thickness of the multi-layer reflective film was set to 280 nm.

Next, a capping layer was formed to have a film thickness of 3.5 nm using ruthenium (Ru) on the multi-layer reflective film. Thus, a reflective part having the multi-layer reflective film and the capping layer was formed on the substrate.

On the capping layer, an absorption layer was formed to have a film thickness of 25 nm using tin oxide. The atomic number ratio of tin and oxygen was 1:2.5 as measured by EDX (energy dispersive X-ray analysis). The measurement by an XRD (X-ray diffractometer) showed that the absorption layer was amorphous although crystallinity was slightly observed.

Next, an outermost layer was formed to have a film thickness of 2 nm using silicon nitride on the absorption layer. Thus, a low reflective part having a film thickness of 27 nm including the absorption layer and the outermost layer was formed on the reflective layer (reflective part). It was found that, when the film thickness of the absorption layer was da and the film thickness of the outermost layer was dc, $0.5 \times da + dc = 14.5$ was established.

Next, on the side on which the multi-layer reflective film was not formed of the substrate, a back surface conductive film was formed to have a film thickness of 100 nm using chromium nitride (CrN).

For the formation of each film on the substrate, a multi-source sputtering apparatus was used. The film thickness of each film was controlled by a sputtering time.

Next, a positive chemically amplified resist (SEBP9012: manufactured by Shin-Etsu Chemical Co., Ltd.) was formed by spin coating to have a film thickness of 120 nm on the low reflective part, and then baked at 110°C for 10 min to form a resist film.

Next, a predetermined pattern was drawn on the positive chemically amplified resist by an electron beam lithography machine (JBX3030: manufactured by JEOL).

Thereafter, prebaking treatment was performed at 110°C for 10 minutes, followed by spray development (SFG3000: manufactured by Sigma Meltec). Thus, a resist pattern was formed.

Next, the outermost layer was patterned by dry etching mainly using a fluorine-based gas with the resist pattern as an etching mask to form an outermost layer pattern on the outermost layer.

Next, the absorption layer was patterned by dry etching mainly using a chlorine-based gas to form an absorption layer pattern. Thus, a low reflective part pattern having the outermost layer pattern and the absorption layer pattern was formed in the low reflective part.

Next, the remaining resist pattern was peeled off. Thus, a reflective photomask of Example 1 was produced.

The produced reflective photomask was immersed in 80°C sulfuric acid for 10 minutes, immersed in a cleaning liquid obtained by mixing ammonia, hydrogen peroxide, and water in a ratio of 1:1:20 using 500 W megasonic waves for 10 minutes, and then cleaned by flowing water for 10 minutes. Thereafter, the film thickness was measured by AFM and compared with the film thickness in the film formation, but no change was observed.

The low reflective part pattern of Example 1 contains an LS (line and space) pattern with a line width of 100 nm, an LS pattern with a line width of 200 nm for film thickness measurement of the absorption layer using AFM, and a 4 mm square low reflective part removed part for EUV reflectance measurement on the reflective photomask for transfer evaluation. The LS pattern with a line width of 100 nm was designed in each of the x-direction and the y-direction such that the influence of the shadowing effect by EUV oblique irradiation was able to be easily viewed.

<Example 2>

The film thickness of the absorption layer was changed to 21 nm. The film thickness of the outermost layer was changed to 4 nm. At this time, when the film thickness of the absorption layer was da and the film thickness of the outermost layer was dc, $0.5 \times da + dc = 14.5$ was established. The film thickness of the low reflective part was 25 nm in total. A reflective photomask of Example 2 was produced in the same manner as in Example 1, except for the above.

<Example 3>

The film thickness of the absorption layer was changed to 39 nm. The film thickness of the outermost layer was changed to 10 nm. At this time, when the film thickness of the absorption layer was da and the film thickness of the outermost layer was dc, $0.5 \times da + dc = 29.5$ was established. The film thickness of the low reflective part was 49 nm in total. A reflective photomask of Example 3 was produced in the same manner as in Example 1, except for the above.

<Example 4>

The material of the outermost layer was changed to tantalum nitride. In the patterning of the outermost layer, an outermost layer pattern was formed by dry etching mainly using a chlorine-based gas. A reflective photomask of Example 4 was produced in the same manner as in Example 1, except for the above. The cleaning was performed in the same manner as in Example 1, and thereafter the film thickness was measured by AFM and compared with the film thickness in the film formation, but no change was observed.

<Example 5>

The film thickness of the absorption layer was changed to 21 nm. The film thickness of the outermost layer was changed to 4 nm. At this time, when the film thickness of the absorption layer was da and the film thickness of the outermost layer was dc, $0.5 \times da + dc = 14.5$ was established. The film thickness of the low reflective part was 25 nm in total. A reflective photomask of Example 5 was produced in the same manner as in Example 4, except for the above.

<Example 6>

The film thickness of the absorption layer was changed to 39 nm. The film thickness of the outermost layer was changed to 10 nm. At this time, when the film thickness of the absorption layer was da and the film thickness of the outermost layer was dc, $0.5 \times da + dc = 29.5$ was established. The film thickness of the low reflective part was 49 nm in total. A reflective photomask of Example 6 was produced in the same manner as in Example 4, except for the above.

<Example 7>

The material of the absorption layer was changed to a mixed material (SnTaO) in which tin oxide and tantalum (Ta) were homogenous in an atomic number ratio of 50:50. A reflective photomask of Example 7 was produced in the same manner as in Example 1, except for the above.

<Example 8>

The film thickness of the absorption layer was changed to 21 nm. The film thickness of the outermost layer was changed to 4 nm. At this time, when the film thickness of the absorption layer was da and the film thickness of the outermost layer was dc, $0.5 \times da + dc = 14.5$ was established. The film thickness of the low reflective part was 25 nm in total. A reflective photomask of Example 8 was produced in the same manner as in Example 7, except for the above.

<Example 9>

The film thickness of the absorption layer was changed to 39 nm. The film thickness of the outermost layer was changed to 10 nm. At this time, when the film thickness of the absorption layer was da and the film thickness of the outermost layer was dc, $0.5 \times da + dc = 29.5$ was established. The film thickness of the low reflective part was 49 nm in total. A reflective photomask of Example 9 was produced in the same manner as in Example 7, except for the above.

<Comparative Example 1>

The film thickness of the absorption layer was changed to 40 nm. Thus, the film thickness of the low reflective part was 42 nm. At this time, when the film thickness of the absorption layer was da and the film thickness of the outermost layer was dc, $0.5 \times da + dc = 22$ was established. A reflective photomask of Comparative Example 1 was produced in the same manner as in Example 1, except for the above.

<Comparative Example 2>

The film thickness of the outermost layer was changed to 10 nm. Thus, the film thickness of the low reflective part was 35 nm. At this time, when the film thickness of the absorption layer was da and the film thickness of the outermost layer was dc, $0.5 \times da + dc = 22.5$ was established. A reflective photomask of Comparative Example 2 was produced in the same manner as in Example 1, except for the above.

<Comparative Example 3>

The material of the outermost layer was changed to tantalum nitride. A reflective photomask of Comparative Example 3 was produced in the same manner as in Comparative Example 1, except for the above.

<Comparative Example 4>

The material of the outermost layer was changed to tantalum nitride. A reflective photomask of Comparative Example 4 was produced in the same manner as in Comparative Example 2, except for the above.

<Comparative Example 5>

The material of the outermost layer was changed to a mixed material (SnTaO) in which tin oxide and tantalum (Ta) were homogenous in an atomic number ratio of 50:50. A reflective photomask of Comparative Example 5 was produced in the same manner as in Comparative Example 1, except for the above.

<Comparative Example 6>

The material of the outermost layer was changed to a mixed material (SnTaO) in which tin oxide and tantalum (Ta) were homogenous in an atomic number ratio of 50:50. A reflective photomask of Comparative Example 6 was produced in the same manner as in Comparative Example 2, except for the above.

<Reference Example>

As a reference example, a conventional existing photomask containing tantalum as the main ingredient was assumed. An absorption layer was formed to have a film thickness of 58 nm using tantalum nitride (TaN) and an outermost layer was formed to have a film thickness of 2 nm using tantalum oxide (TaO), thereby producing a reflective photomask. A reflective photomask of Reference Example was produced in the same manner as in Example 1, except for the above.

<Evaluation>

The reflective photomasks obtained in Examples 1 to 9, Comparative Examples 1 to 6, Reference Example were evaluated for the inspection property and the transfer performance by the following methods. The inspection property was evaluated from a measurement value of the contrast to the inspection light. The transfer performance was confirmed by a wafer exposure evaluation.

<Inspection property>

In Examples 1 to 9, Comparative Examples 1 to 6, Reference Example, the contrast was calculated from a reflectance distribution using an inspection device having a wavelength of 199 nm. NA of the inspection device was 0.85. The x-direction LS pattern was used to measure the reflectance. The contrast was calculated using Equation (1) above, wherein the reflectance from the reflective part of the LS pattern was $R_m$ and the reflectance from the low reflective part was $R_a$. Based on the calculated contrast value, the inspection property was evaluated based on the following two levels: o, ×.

<Evaluation criteria>

o: Case where the contrast value is smaller than - 0.1 or larger than 0.1.
×: Case where the contrast value is -0.1 or more and 0.1 or less.

[Wafer exposure evaluation]

The absorption layer pattern of the reflective photomask produced in each of Examples, Comparative Examples, Reference Example was transferred and exposed onto a semiconductor wafer coated with an EUV positive chemically amplified resist using an EUV exposure apparatus (NXE3300B: manufactured by ASML). At this time, the exposure amount was adjusted such that the x-direction LS pattern was transferred as designed. Thereafter, the observation and the line width measurement of the transferred resist pattern were carried out by an electron beam dimension measuring machine, and then the resolution and the H-V bias were confirmed and evaluated based on the following three levels: o, Δ, ×.

<Evaluation criteria>

∘: Case where the H-V bias is smaller than 2.2 nm (H-V bias value in Reference Example).
Δ: Case where the H-V bias is 2.2 nm or more and 3 nm or less.
×: Case where the H-V bias exceeds 3 nm or less

Table 1 shows the evaluation results above.

[Table 1]

| | Absorotion layer | | Outermost layer | | Low reflective part | Contrast value | Evaluation | |
| --- | --- | --- | --- | --- | --- | --- | --- | --- |
| | Material | Film thickness (nm) | Material | Film thickness (nm) | Total film thickness (nm) | | Inspection property | Transfer performance |
| Ex. 1 | Tin oxide | 25 | Silicon nitride | 2 | 27 | 0.41 | ○ | ○ |
| Ex. 2 | Tin oxide | 21 | Silicon nitride | 4 | 25 | 0.44 | ○ | ○ |
| Ex. 3 | Tin oxide | 39 | Silicon nitride | 10 | 49 | -0.10 | ○ | △ |
| Ex. 4 | Tin oxide | 25 | Tantalum nitride | 2 | 27 | 0.32 | ○ | ○ |
| Ex. 5 | Tin oxide | 21 | Tantalum nitride | 4 | 25 | 0.27 | ○ | ○ |
| Ex. 6 | Tin oxide | 39 | Tantalum nitride | 10 | 49 | -0.21 | ○ | △ |
| Ex. 7 | Tin oxide, Tantalum | 25 | Silicon nitride | 2 | 27 | 0.16 | ○ | ○ |
| Ex. 8 | Tin oxide, Tantalum | 21 | Silicon nitride | 4 | 25 | 0.15 | ○ | ○ |
| Ex. 9 | Tin oxide, Tantalum | 39 | Silicon nitride | 10 | 49 | -0.18 | ○ | ○ |
| Comp Ex. 1 | Tin oxide | 40 | Silicon nitride | 2 | 42 | -0.02 | × | △ |
| Comp Ex. 2 | Tin oxide | 25 | Silicon nitride | 10 | 35 | -0.04 | × | ○ |
| Comp Ex. 3 | Tin oxide | 40 | Tantalum nitride | 2 | 42 | -0.08 | × | △ |
| Comp Ex. 4 | Tin oxide | 25 | Tantalum nitride | 10 | 35 | 0.06 | × | ○ |
| Comp Ex. 5 | Tin oxide, Tantalum | 40 | Silicon nitride | 2 | 42 | -0.02 | × | △ |
| Comp Ex. 6 | Tin oxide, Tantalum | 25 | Silicon nitride | 10 | 35 | 0.06 | × | ○ |

EP 4 293 422 A1

| | Absorotion layer | | Outermost layer | | Low reflective part | Contrast value | Evaluation | |
|---|---|---|---|---|---|---|---|---|
| | Material | Film thickness (nm) | Material | Film thickness (nm) | Total film thickness (nm) | | Inspection property | Transfer performance |
| Ref. Ex. | Tantalum nitride | 58 | Tantalum oxide | 2 | 60 | -0.23 | ○ | Δ |

EP 4 293 422 A1

As shown in Table 1, the evaluation results of Examples 1 to 9, Comparative Examples 1 to 6 show that, when the film thickness of the low reflective part is a film thickness satisfying $0.5 \times da + dc \leq 21.5$ nm or a film thickness satisfying $0.5 \times da + dc \geq 27.5$ nm as in Examples 1 to 9, the transferability is more excellent and the inspection light contrast is higher as compared with the case where the film thickness of the low reflective part is $21.5$ nm $< 0.5 \times da + dc < 27.5$ as in Comparative Examples 1 to 6. For Example 3 and Example 6, no improvement of transferability was observed due to the influence of the shadowing effect. However, an improvement of transferability was observed in Example 9. This showed that, when the total film thickness of the absorption layer and the outermost layer is 49 nm or less, the shadowing effect is reduced, and, when the total film thickness is 45 nm or less, the shadowing effect is more reliably reduced and the transferability is improved.

The reflective photomask blank and the reflective photomask of the present disclosure are not limited to the embodiment and examples described above, and can be variously altered insofar as the features of the invention are not impaired.

Reference Signs List

| | |
|---|---|
| 11 | substrate |
| 12 | multi-layer reflective film |
| 13 | capping layer |
| 14 | absorption layer |
| 15 | outermost layer |
| 16 | back surface conductive film |
| 17 | reflective part |
| 18 | low reflective part |
| 18a | low reflective part pattern |
| 19 | resist film |
| 19a | resist pattern |
| 100 | reflective photomask blank |
| 200 | reflective photomask |

**Claims**

1. A reflective photomask blank comprising:

   a substrate;
   a reflective part formed on the substrate and configured to reflect an incident light; and
   a low reflective part formed on the reflective part and configured to absorb an incident light,
   wherein the low reflective part is a multi-layer structural body having at least two or more layers including an absorption layer and an outermost layer,
   an extinction coefficient k to a wavelength of 13.5 nm of the absorption layer is k > 0.041, and
   a film thickness of the low reflective part is a film thickness satisfying $0.5 \times da + dc \leq 21.5$ nm or a film thickness satisfying $0.5 \times da + dc \geq 27.5$ nm, wherein the film thickness of the absorption layer is da and the film thickness of the outermost layer is dc.

2. The reflective photomask blank according to claim 1, wherein the extinction coefficient k to the wavelength of 13.5 nm of the absorption layer is k > 0.041, and
   a refractive index n of the absorption layer is n ≤ 0.98.

3. The reflective photomask blank according to claim 1 or 2, wherein the absorption layer contains at least one or more layers,

   at least one layer of the absorption layer contains a total of 50 at% or more of one or more kinds of elements selected from a first material group, and
   the first material group contains tellurium (Te), cobalt (Co), nickel (Ni), tin (Sn), platinum (Pt), indium (In), silver (Ag), copper (Cu), zinc (Zn), and bismuth (Bi), and oxides, nitrides, and oxynitrides of tellurium (Te), cobalt (Co), nickel (Ni), tin (Sn), platinum (Pt), indium (In), silver (Ag), copper (Cu), zinc (Zn), or bismuth (Bi).

4. The reflective photomask blank according to any one of claims 1 to 3, wherein the absorption layer contains a total of 50 at% or more of one or more kinds of elements selected from tin (Sn) and indium (In), and oxides, nitrides, and oxynitrides of tin (Sn) and indium (In),

the outermost layer contains a total of 50 at% or more of one or more kinds of elements selected from a second material group, and
the second material group contains silicon (Si), titanium (Ti), tantalum (Ta), Chromium (Cr), molybdenum (Mo), and ruthenium (Ru), and oxides, nitrides, and oxynitrides of silicon (Si), titanium (Ti), tantalum (Ta), Chromium (Cr), molybdenum (Mo), or ruthenium (Ru).

5. The reflective photomask blank according to any one of claims 1 to 4, wherein the low reflective part is a thin film having a total film thickness of the low reflective part of 17 nm or more and 45 nm or less, even when the low reflective part is divided into a plurality of layers, and having an OD value (Optical Density) of 1.0 or more, and contains a material selected from the first material group, and
the first material group contains tellurium (Te), cobalt (Co), nickel (Ni), tin (Sn), platinum (Pt), indium (In), silver (Ag), copper (Cu), zinc (Zn), and bismuth (Bi), and oxides, nitrides, and oxynitrides of tellurium (Te), cobalt (Co), nickel (Ni), tin (Sn), platinum (Pt), indium (In), silver (Ag), copper (Cu), zinc (Zn), or bismuth (Bi).

6. A reflective photomask comprising:

a substrate;
a reflective part formed on the substrate and configured to reflect an incident light; and
a low reflective part formed on the reflective part and configured to absorb an incident light,
wherein the low reflective part is a multi-layer structural body having at least two or more layers including an absorption layer and an outermost layer,
an extinction coefficient k to a wavelength of 13.5 nm of the absorption layer is $k > 0.041$, and
a film thickness of the low reflective part is a film thickness satisfying $0.5 \times da + dc \leq 21.5$ nm or a film thickness satisfying $0.5 \times da + dc \geq 27.5$ nm, wherein the film thickness of the absorption layer is da and the film thickness of the outermost layer is dc.

# FIG. 1

# FIG. 2

# FIG. 3

# FIG. 4

# FIG. 5

# FIG. 6

# FIG. 7

# FIG. 8

18a

18 {
15
14
}

17 {
13
12
}

200

11

16

# FIG. 9

18a

x-DIRECTION LS PATTERN

y-DIRECTION LS PATTERN

18

17

100nm

200nm

EUV IRRADIATION
DIRECTION (6°)

EUV IRRADIATION
DIRECTION (6°)

## INTERNATIONAL SEARCH REPORT

| International application No. |
| --- |
| **PCT/JP2022/004919** |

| A. | CLASSIFICATION OF SUBJECT MATTER |
| --- | --- |

*G03F 1/24*(2012.01)i; *G03F 1/54*(2012.01)i
FI:   G03F1/24; G03F1/54

According to International Patent Classification (IPC) or to both national classification and IPC

| B. | FIELDS SEARCHED |
| --- | --- |

Minimum documentation searched (classification system followed by classification symbols)

G03F1/20-1/86; G03F7/20-7/24; G03F9/00-9/02

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 2020-197606 A (TOPPAN PRINTING CO LTD) 10 December 2020 (2020-12-10)<br>paragraphs [0036]-[0037], [0043], [0049], table 1 | 1-6 |
| X | WO 2010/113700 A1 (TOPPAN PRINTING CO LTD) 07 October 2010 (2010-10-07)<br>paragraphs [0096]-[0099] | 1-6 |
| X | JP 2008-192936 A (CANON INC) 21 August 2008 (2008-08-21)<br>paragraphs [0027], [0029], [0045], fig. 8 | 1-3, 6 |
| A | | 4-5 |
| A | WO 2011/004850 A1 (ASAHI GLASS COMPANY, LIMITED) 13 January 2011<br>(2011-01-13)<br>entire text, all drawings | 1-6 |
| A | JP 2010-103463 A (TOPPAN PRINTING CO LTD) 06 May 2010 (2010-05-06)<br>entire text, all drawings | 1-6 |
| A | JP 2007-250613 A (TOPPAN PRINTING CO LTD) 27 September 2007 (2007-09-27)<br>entire text, all drawings | 1-6 |

☑ Further documents are listed in the continuation of Box C.       ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **01 April 2022** | **19 April 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

| | International application No. |
|---|---|
| | **PCT/JP2022/004919** |

### C. DOCUMENTS CONSIDERED TO BE RELEVANT

| Category* | Citation of document, with indication, where appropriate, of the relevant passages | Relevant to claim No. |
|---|---|---|
| A | JP 2002-329649 A (NIKON CORP) 15 November 2002 (2002-11-15)<br>entire text, all drawings | 1-6 |
| A | JP 2017-525998 A (APPLIED MATERIALS, INCORPORATED) 07 September 2017 (2017-09-07)<br>entire text, all drawings | 1-6 |
| A | JP 2020-106639 A (HOYA CORP) 09 July 2020 (2020-07-09)<br>entire text, all drawings | 1-6 |
| A | WO 2020/100632 A1 (TOPPAN PRINTING CO LTD) 22 May 2020 (2020-05-22)<br>entire text, all drawings | 1-6 |

Form PCT/ISA/210 (second sheet) (January 2015)

**INTERNATIONAL SEARCH REPORT**
Information on patent family members

International application No.

**PCT/JP2022/004919**

| Patent document cited in search report | | | Publication date (day/month/year) | Patent family member(s) | | | Publication date (day/month/year) |
|---|---|---|---|---|---|---|---|
| JP | 2020-197606 | A | 10 December 2020 | WO | 2020/241780 | A1 | |
| | | | | TW | 202109172 | A | |
| WO | 2010/113700 | A1 | 07 October 2010 | US | 2012/0021344 | A1 | |
| | | | | paragraphs [0143]-[0148] | | | |
| | | | | EP | 2416347 | A1 | |
| | | | | KR | 10-2011-0133598 | A | |
| | | | | CN | 102369588 | A | |
| | | | | TW | 201100950 | A | |
| JP | 2008-192936 | A | 21 August 2008 | US | 2008/0186509 | A1 | |
| | | | | paragraphs [0041], [0043], [0059], fig. 8 | | | |
| | | | | KR | 10-2008-0073649 | A | |
| | | | | TW | 200841003 | A | |
| WO | 2011/004850 | A1 | 13 January 2011 | US | 2012/0107733 | A1 | |
| | | | | entire text, all drawings | | | |
| | | | | EP | 2453464 | A1 | |
| | | | | TW | 201122721 | A | |
| | | | | KR | 10-2012-0034074 | A | |
| JP | 2010-103463 | A | 06 May 2010 | (Family: none) | | | |
| JP | 2007-250613 | A | 27 September 2007 | (Family: none) | | | |
| JP | 2002-329649 | A | 15 November 2002 | (Family: none) | | | |
| JP | 2017-525998 | A | 07 September 2017 | US | 2016/0011500 | A1 | |
| | | | | entire text, all drawings | | | |
| | | | | TW | 201614093 | A | |
| | | | | KR | 10-2017-0032379 | A | |
| | | | | CN | 106663602 | A | |
| JP | 2020-106639 | A | 09 July 2020 | WO | 2020/137928 | A1 | |
| | | | | TW | 202041964 | A | |
| WO | 2020/100632 | A1 | 22 May 2020 | CN | 112997116 | A | |
| | | | | TW | 202029279 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6408790 B

- JP 2015084447 A